# EUROPÄISCHE PATENTSCHRIFT

(11) **EP 3 259 770 B1**
(45) Veröffentlichungstag und Bekanntmachung des Hinweises auf die Patenterteilung: **24.06.2020**
(21) Anmeldenummer: 16707659.5
(22) Anmeldetag: 17.02.2016
(51) Int. Cl.: H01H 23/12, H01H 13/14, H01H 3/12

(54) **SCHALTBEDIENANORDNUNG**
SWITCHING CONTROL ARRANGEMENT
DISPOSITIF DE COMMANDE DE COMMUTATION

(30) Priorität: 17.02.2015 DE 102015001839; 17.02.2015 DE 102015001836; 17.02.2015 DE 102015001838
(43) Veröffentlichungstag der Anmeldung: 27.12.2017
(73) Patentinhaber: Marquardt GmbH, 78604 Rietheim-Weilheim (DE)
(72) Erfinder: NEUGART, Elmar, 78048 VS-Villingen (DE)
(74) Vertreter: Otten, Roth, Dobler & Partner mbB Patentanwälte
(86) Internationale Anmeldenummer: PCT/EP2016/053304
(87) Internationale Veröffentlichungsnummer: WO 2016/131848

(56) Entgegenhaltungen:
- EP-A1- 2 485 112
- WO-A1-2013/020236
- WO-A1-2014/198418
- DE-A1- 3 110 886
- FR-A1- 2 837 320
- JP-A- 2004 335 383
- US-A1- 2004 135 767
- US-A1- 2006 185 971
- US-A1- 2007 262 954
- US-A1- 2012 262 256
- US-B1- 6 952 197

## Beschreibung

Die Erfindung betrifft eine Schaltbedienanordnung nach dem Oberbegriff des Patentanspruchs 1.

Eine derartige Schaltbedienanordnung kann beispielsweise als ein Touchpad zur Bedienung von diversen Funktionen ausgestaltet sein. Die Schaltbedienanordnung kann insbesondere in einem Kraftfahrzeug eingesetzt werden.

Eine solche Schaltbedienanordnung weist eine manuell bewegbare Betätigungsfläche zur Bedienung durch den Benutzer auf. Die Betätigungsfläche wirkt mit einem Verschiebemittel, das wenigstens ein eingespannt angeordnetes elastisches Element aufweist, derart zusammen, dass die Betätigungsfläche um wenigstens eine Strecke aus einer Ausgangsstellung bzw. Nullstellung in eine Betätigungsstellung im wesentlichen linear bewegbar ist. Die Betätigungsstellung kann als eine Schaltstellung ausgebildet sein, derart dass die Betätigungsfläche in der Schaltstellung auf ein Schaltelement, einen Sensor o. dgl. schaltend einwirkt. Dabei wird dann ein Schaltsignal erzeugt, das wiederum zur Auslösung einer entsprechend zugeordneten Funktion herangezogen werden kann. Es hat sich herausgestellt, dass Verkippungen der Betätigungsfläche, insbesondere bei deren außermittigen Bedienung durch den Benutzer, auftreten können.

Derartige Schaltbedienanordnungen sind im gattungsgemäßen Druckschrift US6952197 B1 und in den Druckschriften WO 2013/020236 A1, US 2006/185971 A1, FR 2 837 320 A1, DE 31 10 886 A1, JP 2004 335383 A, US 2012/262256 A1, EP 2 485 112 A1 und US 2007/262954 A1 beschrieben.

Der Erfindung liegt die Aufgabe zugrunde, die Schaltbedienanordnung derart weiterzuentwickeln, dass Verkippungen der Betätigungsfläche bei der Bedienung durch den Benutzer weitgehend vermieden sind.

Diese Aufgabe wird bei einer gattungsgemäßen Schaltbedienanordnung durch die kennzeichnenden Merkmale des Anspruchs 1 gelöst.

Bei der erfindungsgemäßen Schaltbedienanordnung ist jedes elastische Element als ein flächenhaftes Element mit geringer Dicke in der Art einer Membran ausgestaltet, derart dass jedes elastische Element im wesentlichen senkrecht zur Oberfläche der Membran elastisch auslenkbar ist. Insbesondere ist dabei jedes elastische Element derart ausgestaltet, dass dessen Dicke klein in Bezug zur flächenhaften Ausdehnung des elastischen Elements ist.

Vorteilhafterweise wird dadurch eine Parallelführung der Betätigungsfläche bei deren Bewegung erzielt, so dass Verkippungen der Betätigungsfläche weitgehend vermieden sind. Weitere Ausgestaltungen der Erfindung sind Gegenstand der Unteransprüche.

Die Betätigungsfläche kann eine flächenhafte Ausgestaltung aufweisen, und zwar derart dass die Betätigungsfläche eine Länge in eine erste Richtung (x-Achse) sowie eine Breite in eine zweite Richtung (y-Achse) aufweist. Desweiteren kann die Betätigungsfläche in eine dritte Richtung (z-Achse), die insbesondere im wesentlichen senkrecht zu den ersten beiden Richtungen (x- und/oder y-Achse) steht, um eine Strecke mittels des Verschiebemittels linear bewegbar sein. Dabei kann die Betätigungsfläche mit einem kleinen Hub betätigbar sein, und zwar so dass die Länge und/oder die Breite der Betätigungsfläche in wenigstens eine der ersten beiden Richtungen (x- und/oder y-Achse) größer als die Strecke zur Führung durch das Verschiebemittel für die Bewegbarkeit der Betätigungsfläche in die dritte Richtung (z-Achse) ist. Dabei kann vorteilhafterweise die Bewegbarkeit der Betätigungsfläche in die dritte Richtung (z-Achse) verkippungsfrei zu den ersten beiden Richtungen (x- und/oder y-Achse) erfolgen.

In üblicher Weise kann für die Schaltbedienanordnung ein Gehäuse vorgesehen sein. Bevorzugterweise ist die Betätigungsfläche an einer Oberfläche des Gehäuses angeordnet, die nach Einbau der Schaltbedienanordnung im Kraftfahrzeug manuell zugänglich für den Benutzer ist. Desweiteren kann der einfachen Bedienbarkeit halber die Betätigungsfläche in Richtung in das Innere des Gehäuses bewegbar sein.

Erfindungsgemäß wirkt die Betätigungsfläche mit einem Rahmen und/oder einem Distanzstück zusammen, wobei die Betätigungsfläche am Rahmen und/oder am Distanzstück befestigt ist.

Jedes elastische Element ist am Rahmen und/oder am Distanzstück eingespannt. Hierfür ist in einfacher Art und Weise der Rahmen mit dem Distanzstück mittels der Membran verbunden. Zwecks präziser Führung für die Bewegung der Betätigungsfläche sind für die Verbindung des Rahmens mit dem Distanzstück zwei im wesentlichen parallel zueinander angeordnete Membranen vorgesehen, die an einander gegenüberliegenden Seiten des Rahmens und/oder des Distanzstücks angeordnet sind.

In erfindungsgemäßer sowie funktionssicherer Ausgestaltung ist der Rahmen unbeweglich im Gehäuse angeordnet. Das Distanzstück ist in einer Aufnahme im Rahmen beweglich angeordnet, und zwar in der Art einer Führung. Zwecks präziser Führung sind die Aufnahme in etwa kreuzförmig sowie das Distanzstück korrespondierend zur Aufnahme ausgestaltet.

In einfacher sowie qualitativ hochwertiger Ausgestaltung können die Membranen, insbesondere an deren Rand, durch Schweißen, Nieten, Schrauben, Kleben, Heißverstemmen, Klemmen o. dgl. am Rahmen und/oder am Distanzstück befestigt sein. In fertigungstechnisch einfacher Art und Weise kann die Verschweißung mittels Ultraschallschweißen, Reibschweißen, Laserschweißen o. dgl. erfolgen.

In kostengünstiger Weise kann jedes elastische Element aus einer steifen Kunststoff-Folie und/oder einer dünnen Kunststoff-Platte bestehen. Zweckmäßigerweise wird die Kunststoff-Folie und/oder die Kunststoff-Platte derart dimensioniert, dass diese eine derartige Steifigkeit besitzt, dass die Membran bei unbetätigter Betätigungsfläche, d.h. also ohne Krafteinwirkung des Benutzers auf die Betätigungsfläche, im wesentlichen keine Verformung aufweist. Als Kunststoffe für die Kunststoff-Folie und/oder die Kunststoff-Platte können beispielsweise Polycarbonat, Polyamid o. dgl. thermoplastische Kunststoffe verwendet werden. Alternativ können die Membranen auch aus einem dünnen Metallblech hergestellt sein, gleichwohl ist jedoch aufgrund der Kostengünstigkeit Kunststoff hierfür bevorzugt. Zweckmäßigerweise können im Hinblick auf die Kostengünstigkeit der Rahmen und/oder das Distanzstück ebenfalls aus Kunststoff, insbesondere aus Polycarbonat, Polyamid o. dgl., bestehen. In fertigungstechnisch einfacher Art und Weise können der Rahmen und/oder das Distanzstück mittels Spritzgießen hergestellt sein.

Das Schaltelement, der Sensor o. dgl. kann aufgrund der schaltenden Einwirkung der Betätigungsfläche in der Schaltstellung ein Signal erzeugen. Dieses Signal kann dann wiederum zum Schalten und/oder zum Auslösen einer zugeordneten Funktion in der Art eines Schaltsignals dienen. Beispielsweise kann dann bei einem erfindungsgemäß ausgestalteten Touchpad als Schaltbedienanordnung durch Bewegung eines Fingers des Benutzers auf und/oder über der Betätigungsfläche eine gewünschte Funktion im Kraftfahrzeug vom Benutzer ausgewählt werden. Anschließend wird die Betätigungsfläche durch Druck mittels des Fingers auf die Betätigungsfläche zur Erzeugung des Schaltsignals bewegt, wodurch wiederum die zugeordnete Funktion im Kraftfahrzeug geschaltet und/oder ausgelöst wird.

Schließlich kann in einfacher Art und Weise ein passiv arbeitendes und/oder ein aktiv arbeitendes Element zur Rückstellung der Betätigungsfläche und/oder zur Erzeugung einer Haptik für die Bewegung der Betätigungsfläche mit der Betätigungsfläche zusammenwirken. In funktionssicherer und dennoch kostengünstiger Art und Weise kann das passiv arbeitende Element aus einer Druckfeder, einem Schalter, einer Haptikmatte o. dgl. bestehen. In ebenfalls funktionssicherer Art und Weise kann das aktiv arbeitende Element aus einem Piezoelement, einem Hubmagnet o. dgl. bestehen.

Das passiv arbeitende und/oder aktiv arbeitende Element kann mit dem Distanzstück zusammenwirken. In einer bevorzugten weiteren Ausgestaltung, die sich durch besonders ergonomische Bedienbarkeit für den Benutzer auszeichnet, kann das passiv arbeitende und/oder aktiv arbeitende Element an einem im Gehäuse befindlichen Ansatz angeordnet sein. Der Ansatz kann in eine Ausnehmung im Distanzstück hineinragen. Weiterhin kann ein dem Ansatz zugewandter Nocken an der Betätigungsfläche angeordnet sein, derart dass die Betätigungsfläche mittels des Nockens mit dem aktiv arbeitendem und/oder passiv arbeitendem Element zusammenwirkt.

Für eine besonders bevorzugte Ausgestaltung der erfindungsgemäßen Schaltbedienanordnung ist nachfolgendes festzustellen.

Bei der Betätigung eines Bedienelements, dessen Bedienfläche eine größere Ausdehnung hat als die zur Verfügung stehende notwendige Führungslänge, entsteht bei außermittiger Betätigung ein Drehmoment. Dieses Drehmoment kann bei bisherigen Bedienelementen in den Führungen derart hohe Reibkräfte hervorrufen, dass es zu einer Verklemmung kommen kann.

Es soll daher eine Bedienfläche realisiert werden, welche derart gelagert ist, dass bei Betätigung durch den Bediener sich die Fläche in z-Richtung linear verschieben lässt. Und zwar soll dabei kein Verkippen der Bedienfläche auftreten. Die verkippfreie, lineare Betätigung soll unabhängig von den gewählten Betätigungspunkten gewährleistet sein. Weiter soll eine geringstmögliche Bautiefe angestrebt werden. Die Lagerung der Bedienfläche soll spielfrei sein.

Beim vorgeschlagenen Bedienelement wird das bei außermittiger Betätigung entstehende Reaktionsmoment durch zwei elastisch verformbare Elemente, die auf Zug beansprucht werden, aufgefangen.

Hierfür wird ein Rahmen mit einem Distanzstück durch zwei dünne, elastische Flächen verbunden. Die Verbindung wird durch Schweißen, Nieten, Schrauben, Kleben, Heißverstemmen, Klemmen o. dgl. realisiert. Die elastischen Flächen sind sowohl am Distanzstück als auch am Rahmen an geeigneter Stelle fest verbunden, ein Loslager ist insoweit nicht notwendig. Zwischen Rahmen und Distanzstück besteht ausreichend Freiraum, damit diese sich bei Betätigung nicht gegenseitig behindern. Sowohl am Rahmen als auch am Distanzstück kann eine Bedienfläche beliebiger Ausprägung angebracht werden. Dient der Rahmen bzw. das Distanzstück als Basis, so kann das Distanzstück bzw. der Rahmen durch eine Krafteinwirkung an beliebiger Stelle in z-Richtung verschoben werden. Um eine haptische Rückmeldung für den Bediener zu ermöglichen, kann an beliebiger Position des beweglichen Teils eine Gegenkraft durch ein passives Element, beispielsweise einen Schalter, eine Haptikmatte o. dgl. oder durch ein aktives Element, beispielsweise ein Piezoelement, einen Hubmagneten o. dgl., eingeleitet werden.

Geschaffen ist somit eine parallel geführte Bedienfläche mit unterschiedlichen Haptikelementen.

Die mit der Erfindung erzielten Vorteile bestehen insbesondere darin, dass
- eine Parallelverschiebung der Betätigungs- bzw. Bedienfläche ohne Verkippung,
- eine reibungsarme Bewegung,
- eine spielfreie Lagerung,
- eine geräuscharme Betätigung,
- eine geringe Anzahl an Bauteilen,
- eine geringe Bautiefe,
- eine einfache Herstellung sowie eine hohe Montagefreundlichkeit,
- eine hohe Flexibilität in der Haptikauslegung und
- eine hohe Flexibilität in der Gestaltung der Betätigungs- bzw. Bedienfläche gegeben sind.

Ausführungsbeispiele der Erfindung mit verschiedenen Weiterbildungen und Ausgestaltungen sind in den Zeichnungen dargestellt und werden im folgenden näher beschrieben. Es zeigen
- Fig. 1: eine Schaltbedienanordnung in perspektivischer Ansicht,
- Fig. 2: die Schaltbedienanordnung aus Fig. 1, wobei das Gehäuse entfernt ist,
- Fig. 3: eine Explosionsdarstellung der Schaltbedienanordnung aus Fig. 2,
- Fig. 4: einen Schnitt entlang der Linie 2-2 in Fig. 1,
- Fig. 5: einen Schnitt wie in Fig. 4, wobei die Befestigungspositionen für die Membran näher dargestellt sind,
- Fig. 6: eine Draufsicht auf Einzelteile der Anordnung aus Fig. 5,
- Fig. 7: einen Schnitt wie in Fig. 5, wobei die Aufnahme der Kräfte bei Betätigung näher dargestellt ist,
- Fig. 8: eine weitere Schaltbedienanordnung in Explosionsdarstellung,
- Fig. 9: die Draufsicht auf die Anordnung nach Fig. 8,
- Fig. 10: einen Schnitt durch Anordnung nach Fig. 8,
- Fig. 11: die Draufsicht auf eine Schaltbedienanordnung gemäß einer weiteren Ausführung,
- Fig. 12: die Schaltbedienanordnung aus Fig. 11 in Explosionsdarstellung,
- Fig. 13: einen Schnitt durch die Schaltbedienanordnung aus Fig. 12,
- Fig. 14: eine Schaltbedienanordnung gemäß abermals einem weiteren Ausführungsbeispiel in perspektivischer Ansicht,
- Fig. 15: die Schaltbedienanordnung aus Fig. 14 in Explosionsdarstellung,
- Fig. 16: ein Einzelteil aus Fig. 15 und
- Fig. 17: diverse Schnitte durch die Schaltbedienanordnung aus Fig. 14.

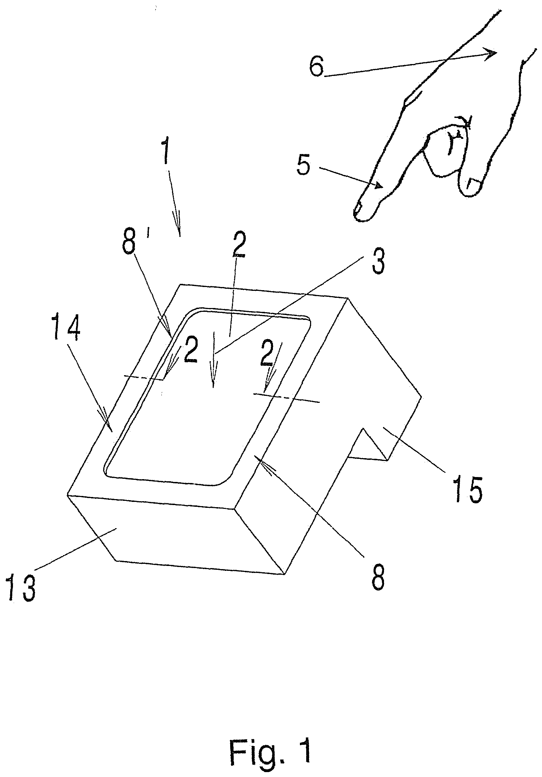

In Fig. 1 ist eine Schaltbedienanordnung 1 in der Art eines Touchpads zu sehen, die insbesondere für ein Kraftfahrzeug Verwendung findet. Die Schaltbedienanordnung 1 weist ein aus Kunststoff bestehendes Gehäuse 13 auf, an dessen einen manuell zugänglichen Oberfläche 14 eine sich in x- und y-Richtung erstreckende Betätigungsfläche 2 bzw. Bedienfläche 2 befindlich ist. Der Benutzer kann durch manuelle Einwirkung mittels eines Elements 5 an der Betätigungsfläche 2 die Schaltbedienanordnung 1 bestimmungsgemäß bedienen. Bei dem Element 5 kann es sich um den Finger 5 einer menschlichen Hand 6 handeln, so dass mittels entsprechender Bewegung des Fingers 5 die bestimmungsgemäße Bedienung ermöglicht ist. Beispielsweise kann die Schaltbedienanordnung 1 in der Mittelkonsole des Kraftfahrzeugs angeordnet sein und für die Bedienung eines Navigationssystems, eines Bildschirms o. dgl. im Kraftfahrzeug vorgesehen sein. Die Schaltbedienanordnung 1 ist mittels eines Steckeranschlusses 15 beispielsweise an ein Bussystem im Kraftfahrzeug anschließbar.

Die Schaltbedienanordnung 1 ist mit einem mit der Betätigungsfläche 2 zusammenwirkenden, nicht weiter gezeigten Sensor versehen. Der beispielsweise kapazitiv und/oder mit Infrarot-Strahlung arbeitende Sensor erzeugt bei Annäherung des Elements 5, hier beispielsweise des Fingers 5 der Hand 6 des Benutzers, an die Betätigungsfläche 2 und/oder bei Berührung der Betätigungsfläche 2 mittels des Elements 5 und/oder bei Druckeinwirkung mittels des Elements 5 auf die Betätigungsfläche 2 ein Signal. Das Signal dient dann zum Schalten und/oder Auslösen und/oder Anwählen einer Funktion im Kraftfahrzeug in der Art eines Schaltsignals.

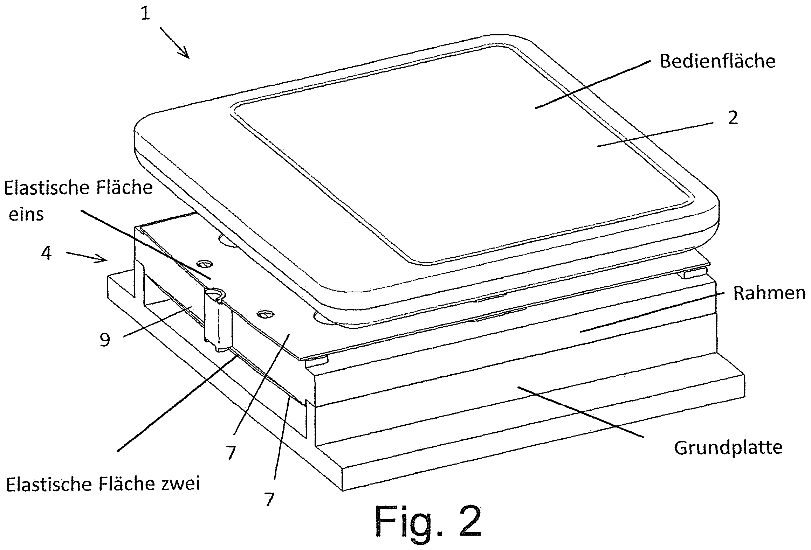

Die Betätigungsfläche 2 der Schaltbedienanordnung 1 ist weiter bewegbar in Richtung 3 (z-Richtung) ausgestaltet, so dass die Betätigungsfläche 2 manuell mittels des Fingers 5 in Richtung 3, und somit in Richtung zum Inneren des Gehäuses 13, bewegt werden kann. Hierfür ist die Betätigungsfläche 2 mit einem geringfügigen Spalt 8' zum umlaufenden Randbereich 8 des Gehäuses 13 ausgestaltet. Wie weiter in Fig. 2 zu sehen ist, wirkt hierzu die Betätigungsfläche 2 mit einem Verschiebemittel 4 derart zusammen, dass die Betätigungsfläche 2 um wenigstens eine Strecke aus einer Ausgangs- beziehungsweise Nullstellung in eine Betätigungsstellung im wesentlichen linear bewegbar ist. Die Betätigungsstellung ist als eine Schaltstellung ausgebildet, derart dass die Betätigungsfläche 2 in der Schaltstellung auf ein nicht weiter gezeigtes, elektrisches Schaltelement schaltend einwirkt. Dabei erzeugt das Schaltelement ein Schaltsignal, das beispielsweise als "Enter"-Befehl und damit zum Schalten und/oder Auslösen der zugeordneten Funktion im Kraftfahrzeug dienen kann. Anstelle eines elektrischen Schaltelements kann auch ein Sensor, wie ein Hall-Sensor, ein induktiver Sensor, eine Lichtschranke o. dgl., Verwendung finden.

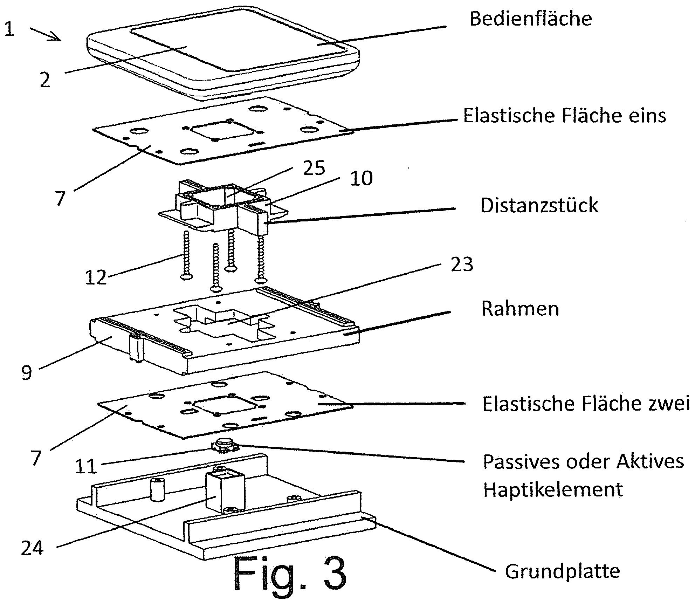

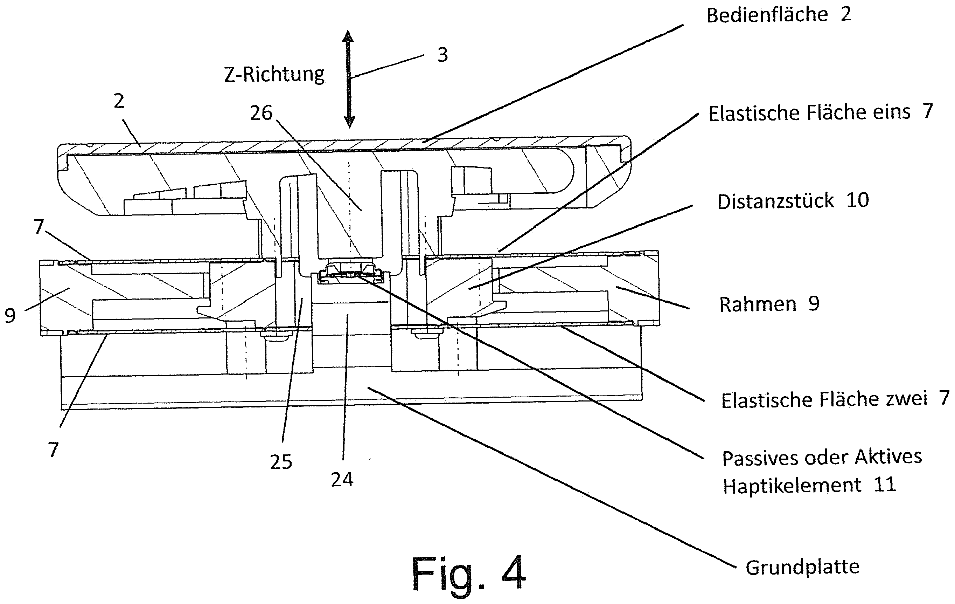

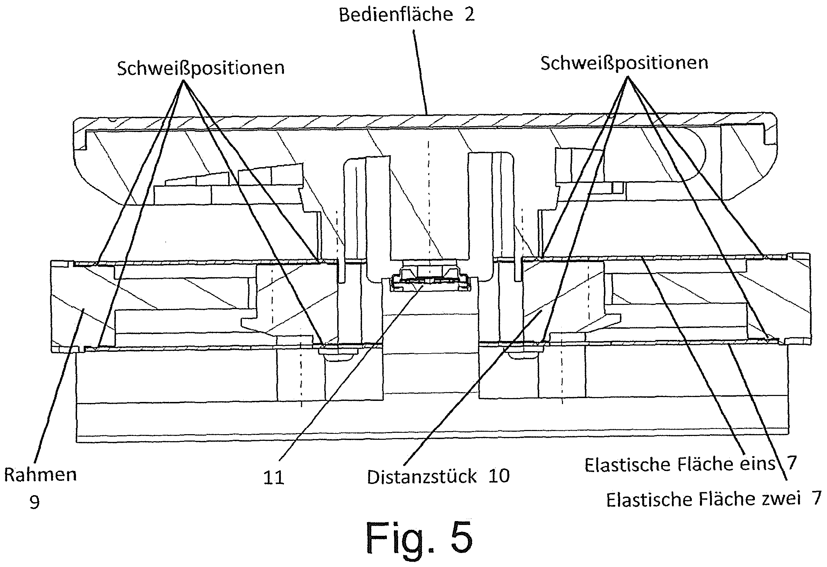

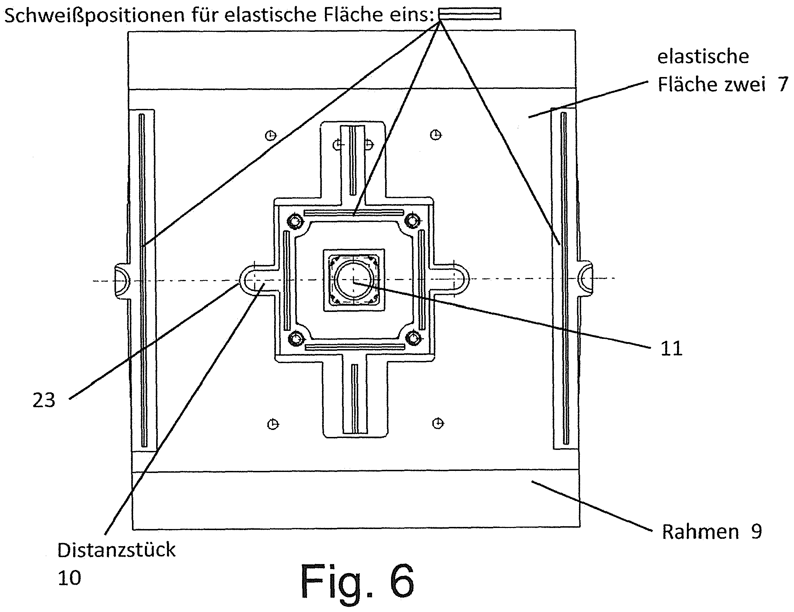

Das Verschiebemittel 4 weist ein eingespannt angeordnetes elastisches Element 7 auf. Wie näher aus Fig. 3 hervorgeht, ist das elastische Element 7 als ein flächenhaftes Element mit geringer Dicke in der Art einer Membran ausgestaltet, derart dass das elastische Element 7 im wesentlichen senkrecht zur Oberfläche der Membran, also in z-Richtung 3, elastisch auslenkbar ist. Insbesondere ist unter geringer Dicke zu verstehen, dass die Dicke des elastischen Elements 7 klein in Bezug zu dessen flächenhafter Ausdehnung ist. Die Betätigungsfläche 2 wirkt mit einem Rahmen 9 und/oder einem Distanzstück 10 zusammen. Vorliegend ist der Rahmen 9 mit dem Distanzstück 10 mittels der Membran 7, und zwar mittels zwei im wesentlichen parallel zueinander angeordneten Membranen 7, die an einander gegenüberliegenden Seiten des Rahmens 9 und/oder des Distanzstücks 10 angeordnet sind, verbunden. Dabei ist das elastische Element 7 am Rahmen 9 und/oder am Distanzstück 10 eingespannt, wie in Fig. 4 zu sehen ist. Hierzu ist die Membran 7 an deren Rand durch Schweißen am Rahmen 9 und/oder am Distanzstück 10 befestigt ist, wobei die Schweißpositionen näher in Fig. 5 oder in Fig. 6 dargestellt sind. Die Verschweißung kann mittels Ultraschallschweißen, Reibschweißen, Laserschweißen o. dgl. erfolgen. Anstelle einer Verschweißung kann die Befestigung der Membran 7 auch durch Nieten, Schrauben, Kleben, Heißverstemmen, Klemmen o. dgl. erfolgen.

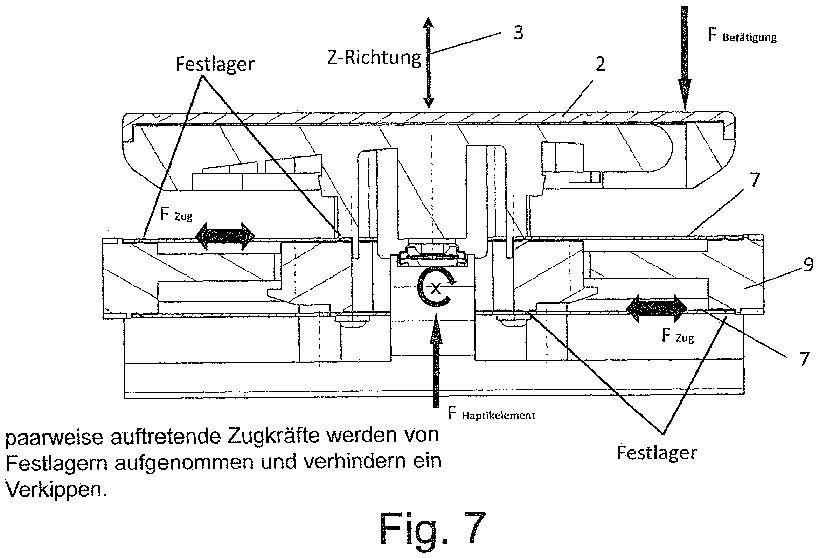

Gemäß Fig. 3 besteht das elastische Element 7 aus einer steifen Kunststoff-Folie und/oder einer dünnen Kunststoff-Platte. Die Kunststoff-Folie und/oder die Kunststoff-Platte ist mit einer derartigen Steifigkeit dimensioniert, dass diese im unbelasteten Zustand im wesentlichen keine Verformung erleidet. Eine elastische Auslenkung der Kunststoff-Folie und/oder der Kunststoff-Platte erfolgt erst bei entsprechender Bewegung der Betätigungsfläche 2 aufgrund der Bedienung durch den Benutzer. Bei der elastischen Auslenkung der Membran 7 werden paarweise auftretende Zugkräfte aufgenommen, wie in Fig. 7 näher dargestellt ist, und verhindern ein Verkippen der Betätigungsfläche 2.

Bei dem Kunststoff für die Kunststoff-Folie und/oder für die Kunststoff-Platte kann es sich um Polycarbonat, Polyamid o. dgl. handeln. Der Rahmen 9 und/oder das Distanzstück 10 können ebenfalls aus Kunststoff, beispielsweise aus Polycarbonat, Polyamid o. dgl., bestehen. Zweckmäßigerweise sind der Rahmen 9 und/oder das Distanzstück 10 mittels Spritzgießen hergestellt.

Der Rahmen 9 ist unbeweglich im Gehäuse 13 angeordnet, wie der Fig. 4 zu entnehmen ist. Das Distanzstück 10 ist gemäß Fig. 6 in einer Aufnahme 23 im Rahmen 9 in der Art einer Führung beweglich angeordnet. Vorliegend sind die Aufnahme 23 in etwa kreuzförmig sowie das Distanzstück 10 korrespondierend zur Aufnahme 23 ausgestaltet. Die Betätigungsfläche 2 ist am Distanzstück 10 mittels Schrauben 12 befestigt, wie in Fig. 3 zu sehen ist. Selbstverständlich kann in einer Art von Wirkungsumkehr anstelle der Befestigung der Betätigungsfläche 2 am Distanzstück 10 auch eine Befestigung der Betätigungsfläche 2 am Rahmen 9 vorgesehen sein sowie das Distanzstück 10 im Gehäuse 13 unbeweglich angeordnet sein, was jedoch nicht weiter gezeigt ist.

Weiterhin kann ein in Fig. 3 gezeigtes passiv arbeitendes und/oder ein aktiv arbeitendes Element 11 zur Rückstellung der Betätigungsfläche 2 in die Ausgangsstellung und/oder zur Erzeugung einer Haptik für die Bewegung der Betätigungsfläche 2 in die Betätigungsstellung mit der Betätigungsfläche 2 zusammenwirken. Das passiv arbeitende Element 11 kann aus einer Druckfeder, einem Schalter, einer Haptikmatte o. dgl. und das aktiv arbeitende Element 11 kann aus einem Piezoelement, einem Hubmagnet o. dgl. bestehen. Das passiv arbeitende und/oder aktiv arbeitende Element 11 ist an einem im Gehäuse 13, und zwar auf einer Grundplatte des Gehäuses 13 befindlichen Ansatz 24 angeordnet. Wie man weiter in Fig. 4 sieht, ragt der Ansatz 24 in eine Ausnehmung 25 im Distanzstück 10 hinein. Weiter ist ein dem Ansatz 24 zugewandter Nocken 26 an der Betätigungsfläche 2 angeordnet. Die Betätigungsfläche 2 wirkt dann bei deren Bewegung mittels des Nockens 26 mit dem aktiv arbeitenden und/oder passiv arbeitenden Element 11 zusammen. Selbstverständlich kann das Element 11 auch direkt mit dem Distanzstück 10 zusammenwirken, was jedoch nicht weiter gezeigt ist.

Zusammenfassend lässt sich somit sagen, dass die Betätigungsfläche 2 der Schaltbedienanordnung 1 eine flächenhafte Gestalt mit einer Länge in eine erste Richtung (beispielsweise die x-Achse) sowie mit einer Breite in eine zweite Richtung (beispielsweise die y-Achse) aufweist. Die Betätigungsfläche 2 ist in eine dritte Richtung (beispielsweise die z-Achse), die im wesentlichen senkrecht zu den ersten beiden Richtungen (x- und/oder y-Achse) steht, um eine Strecke mittels des Verschiebemittels 4 linear bewegbar. Dabei sind die Länge und/oder Breite der Betätigungsfläche 2 in wenigstens eine der ersten beiden Richtungen (x- und/oder y-Achse) größer als die Strecke zur Führung durch das Verschiebemittel 4 für die Bewegbarkeit der Betätigungsfläche 2 in die dritte Richtung (z-Achse). Aufgrund der beschriebenen Ausgestaltung des Verschiebemittels 4 ist die Bewegbarkeit der Betätigungsfläche 2 in die dritte Richtung (z-Achse) verkippungsfrei zu den ersten beiden Richtungen (x- und/oder y-Achse).

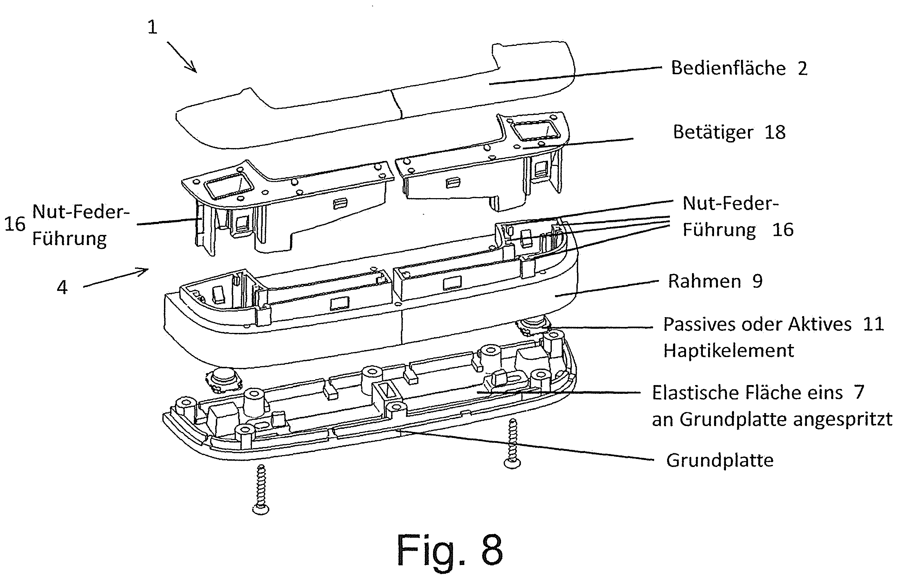

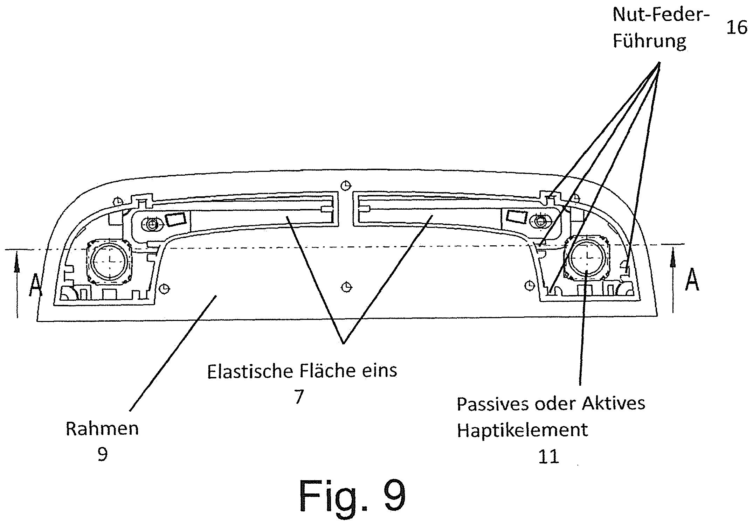

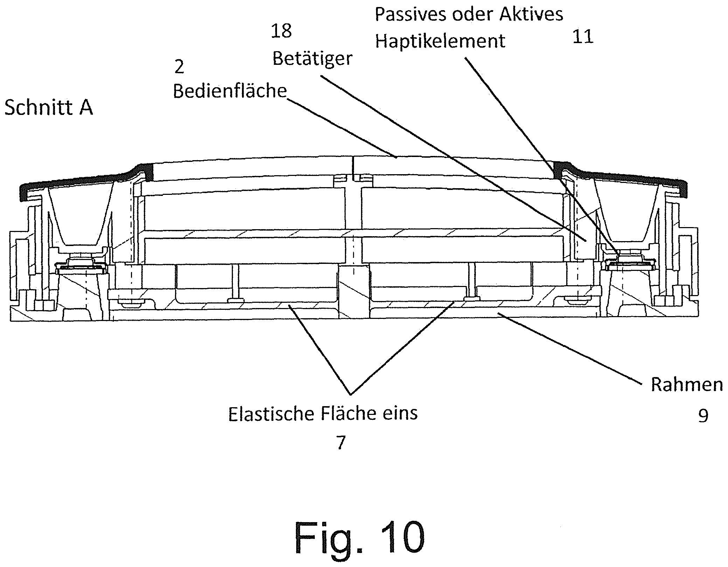

In Fig. 8 bis 10 ist ein weiteres Ausführungsbeispiel für eine Schaltbedienanordnung 1 zu sehen. Diese Schaltbedienanordnung 1 besitzt wiederum ein als flächenhaftes Element mit geringer Dicke in der Art einer Membran 7 ausgestaltetes elastisches Element. Zusätzlich umfasst das Verschiebemittel 4 eine Nut-und-Feder-Führung 16 zur exakten Führung der Betätigungsfläche 2 bei deren Betätigung. Die Betätigungsfläche 2 wirkt auf einen zweiteilig ausgebildeten Betätiger 18 ein, so dass zwei Schaltsignale entsprechend der jeweiligen Betätigung erzeugbar sind.

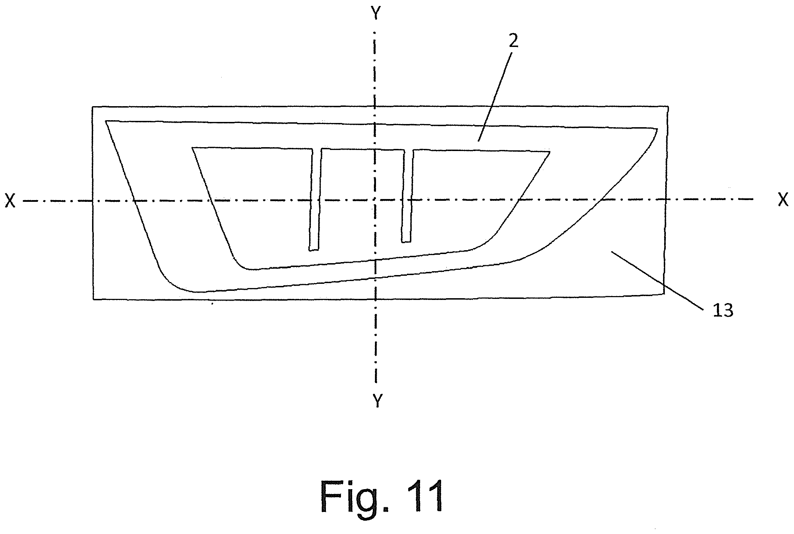

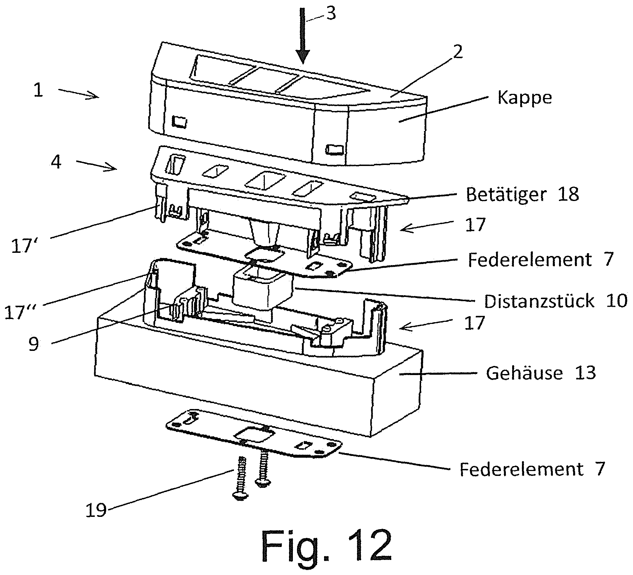

Als ein nochmals weiteres Ausführungsbeispiel ist in Fig. 11 bis Fig. 13 eine Schaltbedienanordnung 1 in der Art einer Kurzhubtaste gezeigt. Eine solche Schaltbedienanordnung 1 lässt sich vorteilhaft in einem Kraftfahrzeug einsetzen. Die Schaltbedienanordnung 1 besitzt eine bewegbare Betätigungsfläche 2 in der Art einer Kappe, wie näher aus Fig. 12 hervorgeht, Die Betätigungsfläche 2 weist gemäß Fig. 11 eine Ausdehnung in eine erste Achse x sowie in eine zweite Achse y auf, wobei die beiden Achsen x, y aufeinander senkrecht stehen. Die Betätigungsfläche 2 wirkt mit einem Verschiebemittel 4 derart zusammen, dass die Betätigungsfläche 2 um wenigstens eine Strecke aus einer Ausgangsstellung in eine Betätigungsstellung im wesentlichen linear in Richtung einer dritten Achse z bewegbar ist, wobei die dritte Achse z im wesentlichen senkrecht auf die erste sowie zweite Achse x, y steht. Die Betätigungsstellung ist als eine Schaltstellung ausgebildet, derart dass die Betätigungsfläche 2 in der Schaltstellung auf ein nicht weiter gezeigtes Schaltelement, einen Sensor o. dgl. zur Erzeugung eines Schaltsignals für das Schalten und/oder Auslösen einer Funktion schaltend einwirkt. Das Verschiebemittel 4 umfasst ein Führungsmittel 17 zur Führung der Betätigungsfläche 2 in und/oder an der ersten Achse x. Das Verschiebemittel 4 umfasst weiterhin wenigstens ein eingespannt angeordnetes elastisches Element 7 zur Führung der Betätigungsfläche 2 in und/oder an der zweiten Achse y. Wie man anhand der Fig. 11 erkennt, ist die Ausdehnung der Betätigungsfläche 2 entlang der ersten Achse x größer als diejenige entlang der zweiten Achse y. Selbstverständlich kann auch umgekehrt die Ausdehnung der Betätigungsfläche 2 entlang der ersten Achse x kleiner als diejenige entlang der zweiten Achse y sein, was jedoch nicht weiter gezeigt ist. Die Länge und/oder die Breite der Betätigungsfläche 2 in wenigstens eine der ersten beiden Achsen x und/oder y ist wiederum größer als die Strecke zur Führung durch das Verschiebemittel 4 für die Bewegbarkeit der Bedienfläche 2 in die Richtung der dritten Achse z. Dabei erfolgt die Bewegbarkeit der Betätigungsfläche 2 in die Richtung der dritten Achse z verkippungsfrei zu den ersten beiden Achsen x und/oder y.

Das elastische Element 7 ist als ein flächenhaftes Element mit geringer Dicke in der Art einer Membran ausgestaltet, derart dass das elastische Element 7 im wesentlichen senkrecht zur Oberfläche der Membran elastisch auslenkbar ist. Das Verschiebemittel 4 umfasst einen Betätiger 18, wobei der Betätiger 18 mit einem Rahmen 9 und/oder einem Distanzstück 10 zusammenwirkt. Der Rahmen 9 ist mit dem Distanzstück 10 mittels der Membran 7, und zwar vorliegend mittels zwei im wesentlichen parallel zueinander, an einander gegenüberliegenden Seiten des Rahmens 9 und/oder des Distanzstücks 10 angeordneten Membranen 7, verbunden. Das Distanzstück 10 ist wiederum am Betätiger 18 befestigt, und zwar mittels einer Verschraubung 19.

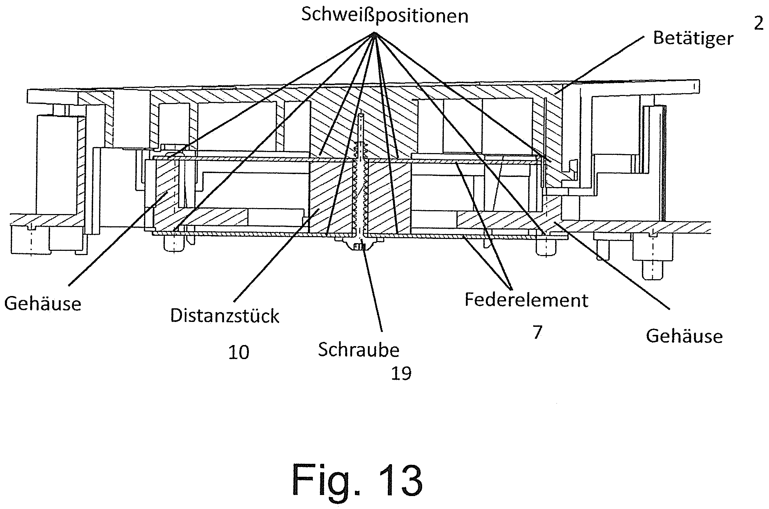

Das Führungsmittel 17 umfasst eine Führungsrippe 17' sowie eine mit der Führungsrippe 17' zusammenwirkende Nut 17". Der eine Bestandteil 17' des Führungsmittels 17 ist am Betätiger 18 sowie der andere Bestandteil 17" des Führungsmittels 17 ist am Rahmen 9 vorgesehen. Das elastische Element 7 besteht wiederum aus einer steifen Kunststoff-Folie und/oder einer dünnen Kunststoff-Platte, wobei das elastische Element 7 am Rahmen 9 und/oder am Distanzstück 10 eingespannt befestigt ist. Die Befestigung kann mittels Verschweißen, Kleben, Vernieten o. dgl. vorgenommen sein, wobei in Fig. 13 die vorgesehenen Schweißpositionen eingezeichnet sind.

Die Betätigungsfläche 2 in der Art einer Kappe ist auf dem Betätiger 18 montiert. Desweiteren ist ein Gehäuse 13 für die Schaltbedienanordnung 1 vorgesehen. Dabei ist die Betätigungsfläche 2 an einer Seite des Gehäuses 13 angeordnet und in Richtung 3 zum Gehäuse 13 bewegbar.

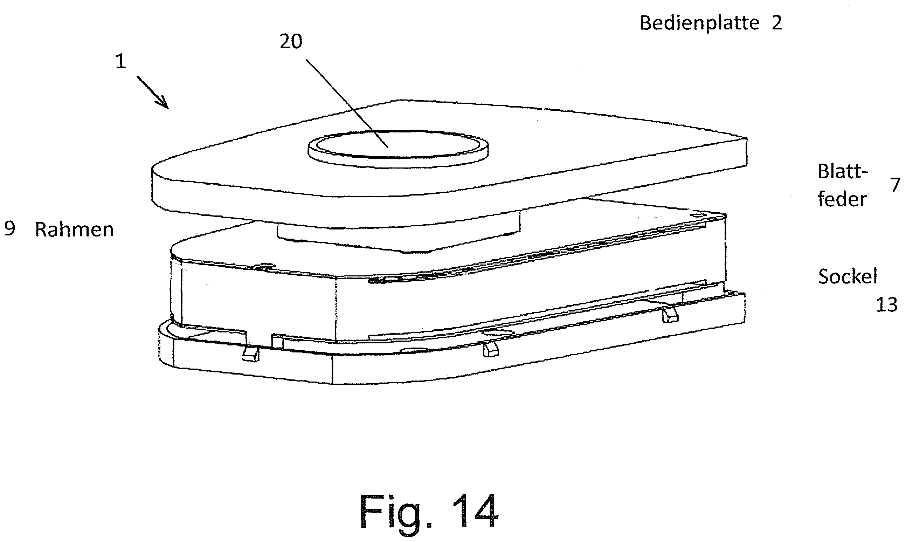

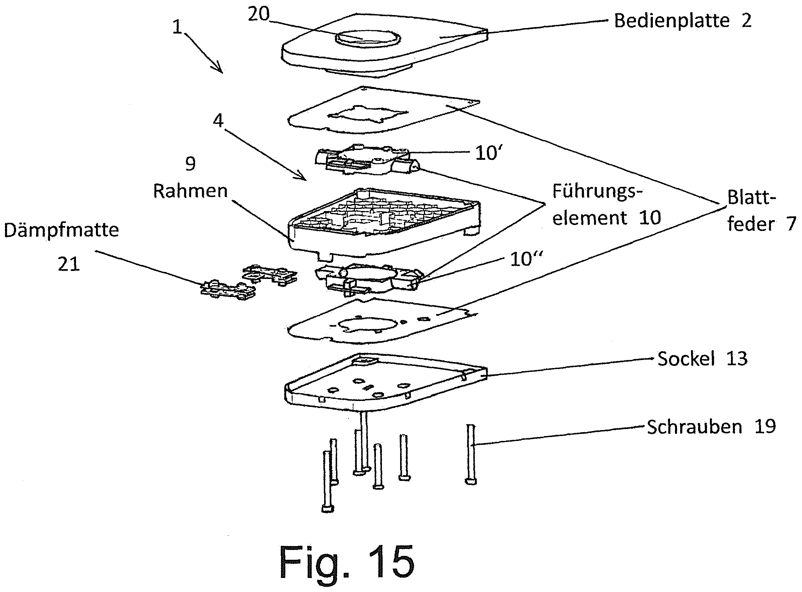

Eine abermals weitere Ausführung für eine Schaltbedienanordnung 1 mit einem Gehäuse 13, die insbesondere in einem Kraftfahrzeug Verwendung findet, ist in der Fig. 14 bis Fig. 17 gezeigt. Die Schaltbedienanordnung 1 besitzt eine an einer Seite des Gehäuses 13 angeordnete, in Richtung zum Gehäuse 13 bewegbare Betätigungsfläche 2, die gemäß Fig. 14 in der Art einer Bedienplatte ausgestaltet ist. Wie man weiter anhand der Fig. 15 sieht, wirkt die Betätigungsfläche 2 mit einem Verschiebemittel 4 derart zusammen, dass die Betätigungsfläche 2 um wenigstens eine Strecke aus einer Ausgangsstellung in eine Betätigungsstellung im wesentlichen linear bewegbar ist. Die Betätigungsstellung ist als eine Schaltstellung ausgebildet, derart dass die Betätigungsfläche 2 in der Schaltstellung auf ein nicht weiter gezeigtes Schaltelement, einen Sensor o. dgl. schaltend zur Erzeugung eines Schaltsignals für das Schalten und/oder Auslösen einer Funktion einwirkt.

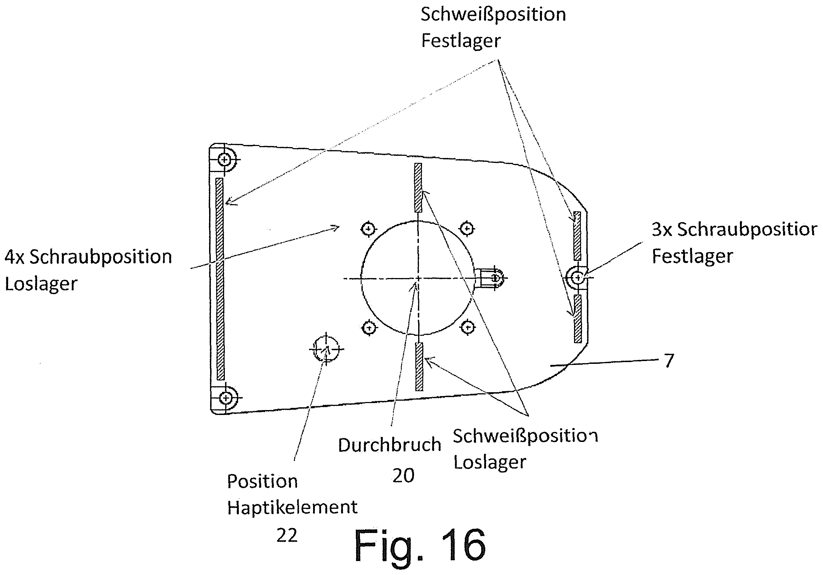

Die Betätigungsfläche 2 ist in einer Richtung asymmetrisch ausgestaltet, und zwar in etwa doppelkeilförmig, wie man beispielsweise anhand der Fig. 16 erkennt. Die Betätigungsfläche 2 weist dabei eine maximale Länge in eine erste Richtung (x) sowie eine maximale Breite in eine zweite Richtung (y) auf. Wiederum ist die Betätigungsfläche 2 in eine dritte Richtung (z), die im wesentlichen senkrecht zu den ersten beiden Richtungen (x und/oder y) steht, um eine Strecke mittels des Verschiebemittels 4 linear bewegbar. Dabei ist wiederum die maximale Länge und/oder die maximale Breite der Betätigungsfläche 2 in wenigstens eine der ersten beiden Richtungen (x und/oder y) größer als die Strecke für die Bewegbarkeit der Betätigungsfläche 2 in die dritte Richtung (z). Die Ausgestaltung des Verschiebemittels 4 bewirkt, dass die Bewegbarkeit der Betätigungsfläche 2 in die dritte Richtung (z) verkippungsfrei zu den ersten beiden Richtungen (x und/oder y) ist.

Das Verschiebemittel 4 weist wenigstens ein eingespannt angeordnetes elastisches Element 7 auf. Weiter umfasst das Verschiebeelement 4 einen Rahmen 9 sowie ein Führungselement 10. Wenigstens ein Teil des Verschiebemittels 4 ist in Bezug auf die Betätigungsfläche 2 in wenigstens einer Richtung außermittig angeordnet, und zwar handelt es sich bei diesem Teil um das Führungselement 10, wie anhand der Fig. 15 zu sehen ist. Das elastische Element 7 ist wiederum als ein flächenhaftes Element mit geringer Dicke in der Art einer Membran ausgestaltet, derart dass das elastische Element 7 im wesentlichen senkrecht zur Oberfläche der Membran elastisch auslenkbar ist. Der Rahmen 9 ist mit dem Führungselement 10 mittels der Membran 7, und zwar vorliegend mittels zwei im wesentlichen parallel zueinander, an einander gegenüberliegenden Seiten des Rahmens 9 und/oder des Führungselements 10 angeordneten Membranen 7, verbunden. Weiter besteht das elastische Element 7 aus einer steifen Kunststoff-Folie und/oder einer dünnen Kunststoff-Platte, wobei das elastische Element 7 am Rahmen 9 und/oder am Führungeselement 10 eingespannt befestigt ist. Die Befestigung kann mittels Verschweißen, Kleben, Vernieten o. dgl. vorgenommen sein, wobei in Fig. 16 die Schweißpositionen für die Membran 7 näher dargestellt sind.

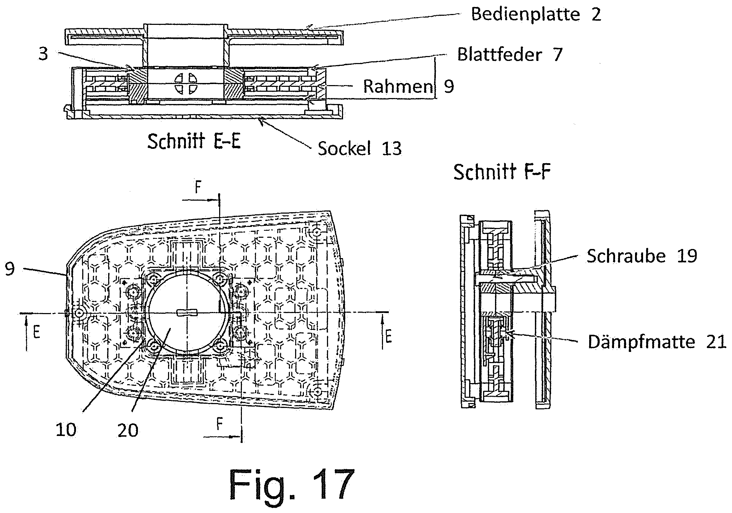

Wie man weiter anhand der Fig. 17 erkennt, ist das Führungselement 10 in der einen Richtung in etwa mittig im Rahmen 9 positioniert. In der anderen Richtung, die in etwa senkrecht auf die eine Richtung steht ist, ist das Führungselement 10 jedoch außermittig im Rahmen 9 positioniert. In der Betätigungsfläche 2 befindet sich gemäß Fig. 14 außermittig ein Durchbruch 20. Dazu korrespondierend ist im Inneren des Führungselementes 10 und/oder dazu korrespondierend im elastischen Element 7 ein kreisrunder Durchbruch 20 angeordnet, wie anhand der Fig. 16 sowie der Fig. 17 zu sehen ist. Das Führungselement 10 besteht aus zwei Teilen 10', 10", wobei zwischen den Teilen 10', 10" des Führungselements 10 und/oder dem Rahmen 9 Dämpfelemente 21 angeordnet sind, wie man auch in Fig. 17 sieht. Die Dämpfelemente 21 dämpfen einen harten Endanschlag der Betätigungsfläche 2 bei deren Betätigung und/oder bei deren Rückstellung. Die Betätigungsfläche 2 ist am Führungselement 10 mittels einer Verschraubung 19 befestigt.

Schließlich wirkt ein Haptikelement zur Rückstellung der Betätigungsfläche 2 und/oder zur Erzeugung einer Haptik für die Bewegung der Betätigungsfläche 2 mit der Betätigungsfläche 2 zusammen. Das Zusammenwirken mit der Betätigungsfläche 2 kann dabei insbesondere über das Führungselement 10 erfolgen. Das Haptikelement ist außermittig bezüglich der Betätigungsfläche 2 im Bereich des Führungselements 10 angeordnet. Die außermittige Position 22 für das Haptikelement ist in Fig. 16 eingezeichnet.

Die Erfindung ist nicht auf die beschriebenen und dargestellten Ausführungsbeispiele beschränkt. Sie umfasst vielmehr auch alle fachmännischen Weiterbildungen im Rahmen der durch die Patentansprüche definierten Erfindung. So kann die erfindungsgemäße Schaltbedienanordnung 1 nicht nur als Touchpad für Kraftfahrzeuge sondern auch für sonstige Schaltelemente mit großflächigen Bedienoberflächen sowie mit linearer Betätigung und gegebenenfalls mit kurzen Hüben Verwendung finden. Desweiteren kann die Schaltbedienanordnung 1 auch in Hausgeräten, Audiogeräten, Videogeräten, Telekommunikationsgeräten o. dgl. eingesetzt werden.

### Bezugszeichen-Liste:

- 1:: Schaltbedienanordnung
- 2:: Betätigungsfläche / Bedienfläche
- 3:: Richtungspfeil
- 4:: Verschiebemittel
- 5:: Finger
- 6:: Hand
- 7:: elastisches Element / Membran
- 8:: Randbereich (von Gehäuse)
- 8':: Spalt (entlang Randbereich)
- 9:: Rahmen
- 10:: Distanzstück / Führungselement
- 10',10":: Teil (von Führungselement)
- 11:: passives/aktives Element
- 12:: Schraube
- 13:: Gehäuse
- 14:: Oberfläche
- 15:: Steckeranschluss
- 16:: Nut- und Federführung
- 17:: Führungsmittel
- 17':: Führungsrippe
- 17":: Nut
- 18:: Betätiger
- 19:: Verschraubung
- 20:: Durchbruch
- 21:: Dämpfelement
- 22:: Position (für Haptikelement)
- 23:: Aufnahme
- 24:: Ansatz
- 25:: Ausnehmung
- 26:: Nocken

## Patentansprüche

1. Schaltbedienanordnung, insbesondere für ein Kraftfahrzeug, mit einer bewegbaren Betätigungsfläche (2), wobei die Betätigungsfläche (2) mit einem Verschiebemittel (4) derart zusammenwirkt, dass die Betätigungsfläche (2) um wenigstens eine Strecke aus einer Ausgangsstellung in eine Betätigungsstellung im wesentlichen linear bewegbar ist, wobei das Verschiebemittel (4) zwei eingespannt angeordnete elastische Elemente (7) aufweist, und wobei insbesondere die Betätigungsstellung als eine Schaltstellung ausgebildet ist, derart dass die Betätigungsfläche (2) in der Schaltstellung auf ein Schaltelement, einen Sensor o. dgl. schaltend einwirkt, wobei die elastischen Elemente (7) als flächenhafte Elemente mit geringer Dicke in der Art einer Membran ausgestaltet sind, insbesondere dass die Dicke der elastischen Elemente (7) klein in Bezug zu dessen flächenhafter Ausdehnung ist, derart dass die elastischen Elemente (7) im wesentlichen senkrecht zur Oberfläche der Membran elastisch auslenkbar sind, wobei die Betätigungsfläche (2) mit einem Rahmen (9) und/oder einem Distanzstück (10) zusammenwirkt, dass die Betätigungsfläche am Rahmen (9) und/oder am Distanzstück (10) befestigt ist, wobei die elastischen Elemente (7) am Rahmen (9) und/oder am Distanzstück (10) eingespannt sind, wobei der Rahmen (9) mit dem Distanzstück (10) mittels der zwei im wesentlichen parallel zueinander angeordneten Membranen (7), die an einander gegenüberliegenden Seiten des Rahmens (9) und/oder des Distanzstücks (10) angeordnet sind, verbunden ist, wobei der Rahmen (9) unbeweglich in einem Gehäuse (13) angeordnet ist, wobei das Distanzstück (10) in einer Aufnahme (23) im Rahmen (9) beweglich in der Art einer Führung angeordnet ist, und wobei weiter vorzugsweise die Aufnahme (23) in etwa kreuzförmig sowie das Distanzstück (10) korrespondierend zur Aufnahme (23) ausgestaltet sind.

2. Schaltbedienanordnung nach Anspruch 1, **dadurch gekennzeichnet, dass** die Betätigungsfläche (2) eine Länge in eine erste Richtung (x-Achse) sowie eine Breite in eine zweite Richtung (y-Achse) aufweist, dass vorzugsweise die Betätigungsfläche (2) in eine dritte Richtung (z-Achse), die insbesondere im wesentlichen senkrecht zu den ersten beiden Richtungen (x- und/oder y-Achse) steht, um eine Strecke mittels des Verschiebemittels (4) linear bewegbar ist, dass weiter vorzugsweise die Länge und/oder Breite der Betätigungsfläche (2) in wenigstens eine der ersten beiden Richtungen (x- und/oder y-Achse) größer als die Strecke zur Führung durch das Verschiebemittel (4) für die Bewegbarkeit der Betätigungsfläche (2) in die dritte Richtung (z-Achse) ist, und dass noch weiter vorzugsweise die Bewegbarkeit der Betätigungsfläche (2) in die dritte Richtung (z-Achse) verkippungsfrei zu den ersten beiden Richtungen (x- und/oder y-Achse) ist.

3. Schaltbedienanordnung nach Anspruch 1 oder 2, **dadurch gekennzeichnet, dass** die Betätigungsfläche (2) an einer Oberfläche (14) des Gehäuses (13) angeordnet ist sowie insbesondere in Richtung in das Innere des Gehäuses (13) bewegbar ist.

4. Schaltbedienanordnung nach einem der Ansprüche 1 bis 3, **dadurch gekennzeichnet, dass** die elastische Elemente (7), insbesondere an deren Rand, durch Schweißen, Nieten, Schrauben, Kleben, Heißverstemmen, Klemmen o. dgl. am Rahmen (9) und/oder am Distanzstück (10) befestigt sind, und dass vorzugsweise die Verschweißung mittels Ultraschallschweißen, Reibschweißen, Laserschweißen o. dgl. erfolgt.

5. Schaltbedienanordnung nach einem der Ansprüche 1 bis 4, **dadurch gekennzeichnet, dass** die elastischen Elemente (7) aus einer steifen Kunststoff-Folie und/oder einer dünnen Kunststoff-Platte besteht, dass es sich vorzugsweise bei dem Kunststoff für die Kunststoff-Folie und/oder für die Kunststoff-Platte um Polycarbonat, Polyamid o. dgl. handelt, dass weiter vorzugsweise der Rahmen (9) und/oder das Distanzstück (10) aus Kunststoff, insbesondere aus Polycarbonat, Polyamid o. dgl., bestehen, und dass noch weiter vorzugsweise der Rahmen (9) und/oder das Distanzstück (10) mittels Spritzgießen hergestellt sind.

6. Schaltbedienanordnung nach einem der Ansprüche 1 bis 5, **dadurch gekennzeichnet, dass** das Schaltelement, der Sensor o. dgl. aufgrund der schaltenden Einwirkung der Betätigungsfläche in der Schaltstellung ein Signal erzeugt, und dass vorzugsweise das Signal zum Schalten und/oder Auslösen einer Funktion in der Art eines Schaltsignals dient.

7. Schaltbedienanordnung nach einem der Ansprüche 1 bis 6, **dadurch gekennzeichnet, dass** ein passiv arbeitendes und/oder ein aktiv arbeitendes Element (11) zur Rückstellung der Betätigungsfläche (2) und/oder zur Erzeugung einer Haptik für die Bewegung der Betätigungsfläche (2) mit der Betätigungsfläche (2) zusammenwirkt, dass vorzugsweise das passiv arbeitende Element (11) aus einer Druckfeder, einem Schalter, einer Haptikmatte o. dgl. besteht, und dass weiter vorzugsweise das aktiv arbeitende Element (11) aus einem Piezoelement, einem Hubmagnet o. dgl. besteht.

8. Schaltbedienanordnung nach dem Anspruch 7, **dadurch gekennzeichnet, dass** das passiv arbeitende und/oder aktiv arbeitende Element (11) an einem im Gehäuse (13) befindlichen Ansatz (24) angeordnet ist, dass vorzugsweise der Ansatz (24) in eine Ausnehmung (25) im Distanzstück (10) hineinragt, und dass weiter vorzugsweise ein dem Ansatz (24) zugewandter Nocken (26) an der Betätigungsfläche (2) angeordnet ist, derart dass die Betätigungsfläche (2) mittels des Nockens (26) mit dem aktiv arbeitenden und/oder passiv arbeitenden Element (11) zusammenwirkt.

## Claims

1. A switching control arrangement, in particular for a motor vehicle, having a movable actuating surface (2), wherein the actuating surface (2) interacts with a displacement means (4) in such a way that the actuating surface (2) can be moved substantially linearly by at least a distance from a starting position into an actuating position, wherein the displacement means (4) has two clamped elastic elements (7), and wherein in particular the actuating position is designed as a switching position, such that, in the switching position, the actuating surface (2) acts in a switching manner on a switching element, a sensor or the like, wherein the elastic elements (7) are designed as flat elements with a small thickness in the manner of a membrane, in particular such that the thickness of the elastic elements (7) is small in relation to its planar extension, such that the elastic elements (7) are elastically deflectable substantially perpendicular to the surface of the membrane, wherein the actuating surface (2) interacts with a frame (9) and/or a spacer (10), the actuating surface being attached to the frame (9) and/or the spacer (10), wherein the elastic elements (7) are clamped on the frame (9) and/or on the spacer (10), wherein the frame (9) with the spacer (10) are connected by means of the two membranes (7) arranged substantially parallel to one another, which are located on opposite sides of the frame (9) and/or the spacer (10), wherein the frame (9) is arranged immovably in a housing (13), wherein the spacer (10) is movably arranged in a recess (23) in the frame (9) in the manner of a guide, and wherein further preferably the recess (23) is designed to be approximately cruciform and the spacer (10) is designed to correspond to the recess (23).

2. The switching control arrangement according to claim 1, **characterised in that** the actuating surface (2) has a length in a first direction (x-axis) and a width in a second direction (y-axis), **in that** preferably the actuating surface (2) can be moved linearly in a third direction (z-axis), which is in particular substantially perpendicular to the first two directions (x-axis and/or y-axis), by a distance by means of the displacement means (4), **in that** further preferably the length and/or width the actuating surface (2) in at least one of the first two directions (x-axis and/or y-axis) is greater than the distance for the guidance by the displacement means (4) for the mobility of the actuating surface (2) in the third direction (z-axis), and **in that** even more preferably the mobility of the actuating surface (2) in the third direction (z-axis) is tilt-free to the first two directions (x-axis and/or y-axis).

3. The switching control arrangement according to claim 1 or 2, **characterised in that** the actuating surface (2) is arranged on a surface (14) of the housing (13) and in particular can be moved in the direction of the interior of the housing (13).

4. The switching control arrangement according to any one of claims 1 to 3, **characterised in that** the elastic elements (7), in particular at the edge thereof, are attached by means of welding, riveting, screwing, gluing, hot caulking, clamping or the like to the frame (9) and/or the spacer (10), and that preferably the welding is carried out by means of ultrasonic welding, friction welding, laser welding or the like.

5. The switching control arrangement according to any one of claims 1 to 4, **characterised in that** the elastic elements (7) consist of a rigid plastic film and/or a thin plastic plate, **in that** preferably the plastic for the plastic film and/or for the plastic plate is polycarbonate, polyamide or the like, **in that** further preferably the frame (9) and/or the spacer (10) consist of plastic, in particular of polycarbonate, polyamide or the like, and **in that** even further preferably the frame (9) and/or the spacer (10) are produced by means of injection moulding.

6. The switching control arrangement according to any one of claims 1 to 5, **characterised in that** the switching element, the sensor or the like produces a signal due to the switching effect of the actuating surface in the switching position, and **in that** preferably the signal is used for switching and/or triggering a function in the manner of a switching signal.

7. The switching control arrangement according to any one of claims 1 to 6, **characterised in that** a passively working and/or an actively working element (11) for resetting the actuating surface (2) and/or for generating a haptic for the movement of the actuating surface (2) interacts with the actuating surface (2), **in that** preferably the passively working element (11) consists of a compression spring, a switch, a haptic mat or the like, and **in that** further preferably the actively working element (11) consists of a piezoelectric element, a lifting magnet or the like.

8. The switching control arrangement according to claim 7, **characterised in that** the passively working and/or actively working element (11) is arranged on a projection (24) located in the housing (13), **in that** preferably the projection (24) protrudes into a recess (25) in the spacer (10), and **in that** a lobe (26) facing the projection (24) is further preferably arranged on the actuating surface (2), such that the actuating surface (2) interacts by means of the lobe (26) with the actively working and/or passively working element (11).

## Revendications

1. Dispositif de commande de commutation, en particulier pour un véhicule automobile, avec une surface d'actionnement mobile (2), la surface d'actionnement (2) coopérant avec un moyen de déplacement (4) de sorte que la surface d'actionnement (2) puisse être déplacée de manière essentiellement linéaire sur au moins une distance d'une position de départ à une position d'actionnement, le moyen de déplacement (4) présentant deux éléments élastiques disposés de manière serrée (7) et en particulier la position d'actionnement étant conçue comme une position de commutation, de sorte que la surface d'actionnement (2), dans la position de commutation, exerce une action de commutation sur un élément de commutation, un capteur ou similaire, dans lequel les éléments élastiques (7) sont conçus comme des éléments plats d'une faible épaisseur à la manière d'une membrane, en particulier, l'épaisseur des éléments élastiques (7) étant petite par rapport à son extension surfacique, de sorte que les éléments élastiques (7) puissent être orientés dans le sens sensiblement perpendiculaire à la surface de la membrane de manière élastique, la surface d'actionnement (2) coopérant avec un cadre (9) et/ou une entretoise (10), la surface d'actionnement étant fixée au cadre (9) et/ou à l'entretoise (10), les éléments élastiques (7) sont serrés sur le cadre (9) et/ou sur l'entretoise (10), le cadre (9) étant relié à l'entretoise (10) au moyen des deux membranes (7) disposées sensiblement parallèles entre elles, lesquelles sont situées sur les côtés opposés du cadre (9) et/ou l'entretoise (10), le cadre (9) étant disposé de manière inamovible dans un boîtier (13), l'entretoise (10) étant mobile dans un logement (23) dans le cadre (9) à la manière d'un guide et de préférence encore le logement (23) étant approximativement cruciforme et l'entretoise (10) est conçue pour correspondre au logement (23).

2. Dispositif de commande de commutation selon la revendication 1, **caractérisé en ce que** la surface d'actionnement (2) a une longueur dans une première direction (axe x) et une largeur dans une deuxième direction (axe y), que de préférence la surface d'actionnement (2) se trouve dans une troisième direction (axe z), laquelle est en particulier essentiellement perpendiculaire aux deux premières directions (axe x et/ou y), afin de pouvoir être déplacée linéairement d'une distance au moyen d'un moyen de déplacement (4), que de préférence encore la longueur et/ou la largeur de la surface d'actionnement (2) est supérieure à la distance de guidage par le moyen de déplacement (4) dans au moins l'une des deux premières directions (axe x et/ou y) pour la mobilité de la surface d'actionnement (2) dans la troisième direction (axe z) et que de manière encore plus préférée la mobilité de la surface d'actionnement (2) est sans jeu dans la troisième direction (axe z) vers les deux premières directions (axe x et/ou y).

3. Dispositif de commande de commutation selon la revendication 1 ou 2, **caractérisé en ce que** la surface d'actionnement (2) est disposée sur une surface (14) du boîtier (13) et peut être déplacée en particulier en direction de l'intérieur du boîtier (13).

4. Dispositif de commande de commutation selon l'une des revendications 1 à 3, **caractérisé en ce que** les éléments élastiques (7) sont fixés, notamment au bord de ceux-ci, par soudage, rivetage, vissage, collage, calfeutrage à chaud, serrage ou similaire au cadre (9) et/ou à l'entretoise (10) et que de préférence le soudage est effectué au moyen d'un soudage par ultrasons, d'un soudage par friction, d'un soudage au laser ou similaire.

5. Dispositif de commande de commutation selon l'une des revendications 1 à 4, **caractérisé en ce que** les éléments élastiques (7) sont constitués d'un film plastique rigide et/ou d'une fine plaque plastique, qu'il s'agit de préférence de plastique pour le film plastique et/ou de polycarbonate, polyamide ou similaire pour la plaque en plastique, que de préférence encore le cadre (9) et/ou l'entretoise (10) sont en plastique, en particulier en polycarbonate, polyamide ou similaire et que encore plus de préférence le cadre (9) et/ou l'entretoise (10) sont réalisés par moulage par injection.

6. Dispositif de commande de commutation selon l'une des revendications 1 à 5, **caractérisé en ce que** l'élément de commutation, le capteur ou similaire génère un signal en raison de l'effet commutant de la surface d'actionnement en position de commutation et que de préférence le signal sert à commuter et/ou déclencher une fonction à la manière d'un signal de commutation.

7. Dispositif de commande de commutation selon l'une des revendications 1 à 6, **caractérisé en ce qu'**un élément fonctionnant passivement et/ou activement (11) coopère avec la surface d'actionnement (2) pour réinitialiser la surface d'actionnement (2) et/ou pour générer un haptique pour le mouvement de la surface d'actionnement (2), que l'élément fonctionnant passivement (11) se compose de préférence d'un ressort de compression, d'un interrupteur, d'un tapis haptique ou similaire et que l'élément fonctionnant activement (11) se compose de préférence d'un élément piézoélectrique, d'un aimant de levage ou similaire.

8. Dispositif de commande de commutation selon la revendication 7, **caractérisé en ce que** l'élément fonctionnant passivement et/ou activement (11) est disposé sur un épaulement (24) situé dans le boîtier (13), que de préférence l'épaulement (24) fait saillie dans un évidement (25) dans l'entretoise (10) et qu'une came (26) faisant face à l'épaulement (24) est disposée de préférence sur la surface d'actionnement (2), de sorte que la surface d'actionnement (2) coopère avec l'élément fonctionnant activement et/ou passivement (11) au moyen de la came (26).
